(19) Europäisches Patentamt

European Patent Office

Office européen des brevets

(11) Veröffentlichungsnummer: **0 278 432 B1**

(12) **EUROPÄISCHE PATENTSCHRIFT**

(45) Veröffentlichungstag der Patentschrift: **11.12.91**

(51) Int. Cl.⁵: **H01L 25/10, H03K 17/08**

(21) Anmeldenummer: **88101707.3**

(22) Anmeldetag: **05.02.88**

(54) **Brückenzweig mit Freilaufdioden.**

(30) Priorität: **06.02.87 DE 3703660**

(43) Veröffentlichungstag der Anmeldung:
**17.08.88 Patentblatt 88/33**

(45) Bekanntmachung des Hinweises auf die
Patenterteilung:
**11.12.91 Patentblatt 91/50**

(84) Benannte Vertragsstaaten:
**CH DE FR GB IT LI**

(56) Entgegenhaltungen:
**EP-A- 0 166 968**
**US-A- 4 639 823**

**REVUE GENERALE DE L'ELECTRICITE, Nr. 9,
September 1981, Seiten 648-655, Paris, FR; C.
GOELDEL et al.: "Utilisation et protection des
transistors MOSFET dans la commutation
des charges inductives de quelques kilowatts"**

**ELEKTRIE, Band 36, Nr. 7, 1982, Seiten
366-370, Berlin, DD; F. FISCHER et al.:
"Leistungs-MOSFETs in der Energieelektronik Teil IV und Schluss"**

**ELECTRONIC DESIGN, Band 29, Nr. 18, September 1981, Seiten 13,16, WASECA, Minnesota, US; W.S. MORDAUNT: "Corrections and
protections"**

(73) Patentinhaber: **SIEMENS AKTIENGESELL-
SCHAFT
Wittelsbacherplatz 2
W-8000 München 2(DE)**

(72) Erfinder: **Feldvoss, Mario, Dipl.-Ing. (FH)
Senftenauerstrasse 20
W-8000 München 21(DE)**
Erfinder: **Miller, Gerhard, Dr., Ing.
Steinacker 3
W-8916 Penzing(DE)**
Erfinder: **Porst, Alfred
Kurt-Floericke-Strasse 14
W-8000 München 60(DE)**

## Beschreibung

Die Erfindung bezieht sich auf ein Halbleiterbauelement mit zwei in Reihe geschalteten Halbleiterschaltern, denen jeweils eine Freilaufdiode antiparallel geschaltet ist, mit einer ersten Anschlußklemme zwischen den beiden Halbleiterschaltern und mit zwei Anschlußklemmen zur Zuführung einer Zwischenkreisspannung.

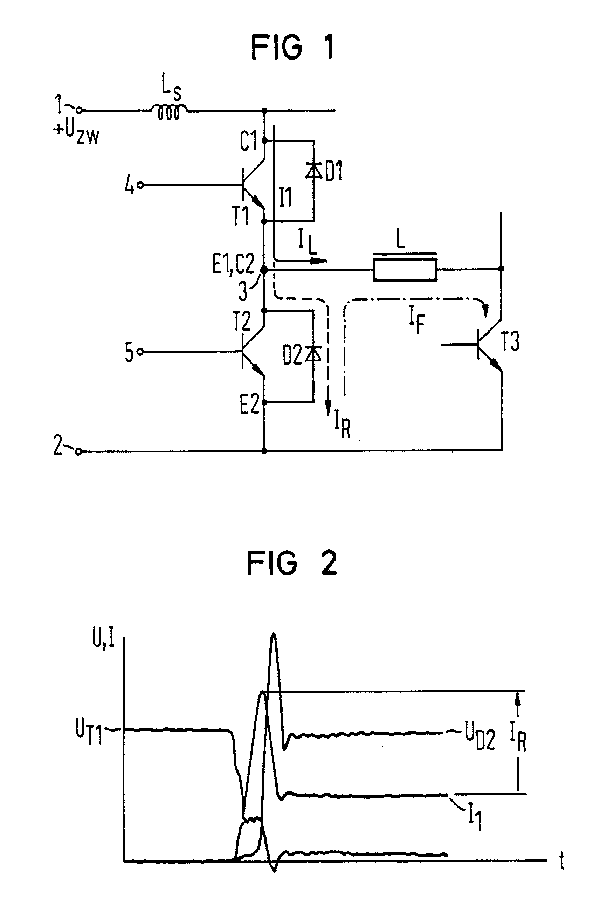

Eine Schaltungsanordnung mit den genannten Komponenten ist beispielsweise in der Zeitschrift "Elektronik" 1980, Heft 24, Seiten 91 bis 24, insbesondere in Verbindung mit Bild 3 beschrieben worden. Die genannte Schaltungsanordnung findet insbesondere bei Invertern Anwendung. Die Schalter werden dabei impulsweise mit einer Frequenz angesteuert, die hoch ist im Vergleich zu der Frequenz derjenigen Spannung, die an der Last erzeugt werden soll. Hierbei treten Probleme auf, die anhand der Figur 1 erläutert werden.

In Figur 1 ist ein Brückenzweig eines Inverters dargestellt, dessen Halbleiterschalter aus je einem Transistor T1 bzw. T2 bestehen. Der Kollektor des Transistors T1 ist mit C1 bezeichnet und über eine die gesamte Streuinduktivität des Kreises repräsentierende Induktivität $L_s$ mit einer Eingangsklemme 1 verbunden. Der Emitter ist mit E1 bezeichnet. Der Emitter E2 des Transistors T2 liegt an einer Eingangsklemme 2. Sein Kollektor C2 und E1 liegen an der Anschlußklemme 3. An der Klemme 3 liegt eine induktive Last L, deren anderer Anschluß über einen weiteren Transistor T3 mit der Klemme 2 verbunden ist. Zwischen den Klemmen 1 und 2 liegt eine Zwischenkreisspannung $U_{zw}$. Den Transistoren T1, T2 sind Dioden D1 bzw. D2 antiparallel geschaltet.

Zur Erläuterung der Funktion wird davon ausgegangen, daß T1 leitend ist. Dann fließt ein Strom $I_L$ in Richtung des Pfeils durch die Last L. Wird T1 ausgeschaltet, so treibt die Spannung an L einen Freilaufstrom $I_F$ durch T3 und D2. Dieser Strom ist strichpunktiert dargestellt. Wird nun beim nächsten Takt T1 wieder eingeschaltet, so steigt der Strom $I_1$ durch T1 an. Da der Strom $I_L$ durch L bezogen auf die Taktfrequenz der Schaltung im wesentlichen konstant ist, geht der Diodenstrom $I_D = I_L - I_1$ zurück. Da die Diode D2 mit Ladungsträgern überschwemmt war, fließt ein Teil von $I_1$ als Rückstrom $I_R$ (gestrichelter Pfeil) durch D2 zur Klemme 2.

Die geschilderten Verhältnisse sind anhand von Strom / Spannungs-Zeitdiagrammen in Figur 2 gezeigt. Hier ist die Spannung $U_{T1}$ an T1, der Strom $I_1$ und die Spannung $U_{D2}$ an D2 aufgetragen. Der Diodenstrom $I_D$ ergibt sich aus $I_L - I_1$. Der als Rückstrom fließende Diodenstrom $I_D$ nimmt hier Werte an, die wesentlich höher sind als der Laststrom. Mit ansteigendem Rückstrom nimmt die Diode Sperrspannung $(U_{D2})$ auf und der Rückstrom nimmt ab. Beim Rückgang des Stroms $I_1$ entsteht - hervorgerufen durch die Streuinduktivität $L_s$ - an D2 eine Spannungsspitze, die wesentlich höher als die Zwischenkreisspannung $U_{ZW}$ ist.

Durch die hohe Diodenspannung und den hohen Rückstrom kann unter Umständen die dynamische Sperrfähigkeit der Diode überschritten und die Diode zerstört werden. Eine Reduzierung der Spannungsspitze kann durch eine RCD-Beschaltung parallel zur Diode erreicht werden. Diese Beschaltung bringt aber zusätzlich Verluste und begrenzt außerdem den Schaltfrequenzbereich.

Ziel der vorliegenden Erfindung ist es, ein auf der beschriebenen Schaltungsanordnung basierendes verlustarmes Halbleiterbauelement anzugeben, bei dem eine Zerstörung der Diode vermieden wird.

Dieses Ziel wird dadurch erreicht, daß jeder der Halbleiterschalter mindestens eine Laststrom-Leitung und mindestens eine Steuerstrom-Leitung aufweist, und daß mindestens eine der Steuerstrom-Leitungen und mindestens eine der Laststrom-Leitungen derart zueinander angeordnet sind, daß bei einem Stromanstieg in der Laststrom-Leitung in der Steuerstrom-Leitung eine Gegenspannung induziert wird.

Weiterbildungen der Erfindung sind Gegenstand der Unteransprüche. Die Erfindung wird anhand von Ausführungsbeispielen in Verbindung mit den Figuren 3 bis 9 näher erläutert. Es zeigen:

Figur 3     die Aufsicht auf ein erstes Ausführungsbeispiel,

Figur 4     die Aufsicht auf ein zweites Ausführungsbeispiel,

Figur 5     eine Variante der Leiterführung,

Figur 6     ein drittes Ausführungsbeispiel,

Figur 7     ein Strom/Spannungs-Zeitdiagramm bei einer erfindungsgemäßen Anordnung,

Figur 8     eine Ausführungsform eines Halbleiterschalters mit Bipolartransistoren und

Figur 9     ein Prinzipschaltbild eines Inverters mit Leistungs-MOSFET.

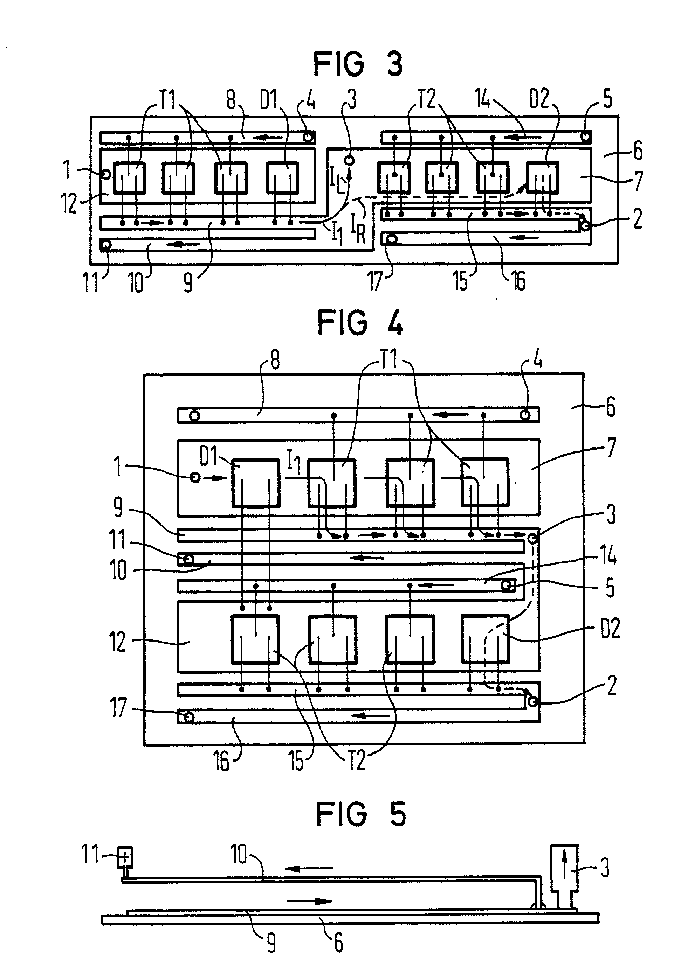

Der in Figur 1 dargestellte Brückenzweig mit den Schaltern T1 und T2 und den Freilaufdioden D1 und D2 wird nach Figur 3 auf einem isolierenden Substrat 6 aufgebaut. Die Bezeichnung der Anschlußklemmen stimmt mit der Bezeichnung nach Figur 1 überein. Auf dem Substrat 6 ist eine streifenförmige Kollektorleitung 12 aufgebracht, auf dem ein oder mehrere Halbleiterkörper sitzen. Hier sind drei Halbleiterkörper dargestellt, die einander parallel geschaltet sind. Für den Fall, daß es sich um Bipolartransistoren handelt, sitzen sie mit ihrer Kollektorseite auf der Leitung 12. Auf ihr ist auch der Halbleiterkörper der Diode D1 angeordnet und kathodenseitig mit ihr verbunden. An einer Längsseite der Leitung 12 ist eine Basisstrom-Leitung 8 angeordnet, über die der Basisstrom zugeführt wird. An der anderen Längsseite der Kollektorleitung 12 ist eine Emitterleitung 9 vorgesehen. Parallel zur Emitterleitung 9 liegt eine weitere Leitung 10, die den Basisstrom wieder zum Steuerkreis zurückführt (Basisstrom-Rückleitung). Sie ist an der rechten Seite mit der Emitterleitung 9 verbunden. Am linken Ende weist sie eine Anschlußklemme 11 auf.

Auf dem Substrat 6 ist eine zweite streifenförmige Kollektorleitung 7 vorgesehen, auf der die zum Transistor T2 gehörenden Halbleiterkörper angeordnet sind. Sie sitzen mit der Kollektorseite auf der Kollektorleitung. Auf der Kollektorleitung 7 sitzt der Halbleiterkörper der Diode D2 und ist kathodenseitig mit dieser verbunden. Entsprechend der linken Seite (T1, D1) ist hier auf der einen Seite von 7 eine Basisstrom-Leitung und auf der anderen Seite eine Emitterleitung 15 und eine Basisstrom-Rückleitung 16 angeordnet. Die beiden letzteren Leitungen sind auf der rechten Seite miteinander verbunden. Die Leitung 16 trägt an ihrem linken Ende einen Anschlußkontakt 17. Die Transistoren T1 und T2 sind dadurch hintereinander geschaltet, daß die Emitterleitung 9 mit der Kollektorleitung 7 verbunden ist.

Für die Funktion der induktiven Gegenkopplung zwischen Steuerstrom und Laststrom führenden Leitungen ist erstens wesentlich, daß die Rückleitungen 10, 16 mindestens teilweise den Emitterleitungen 9 bzw. 15 parallel liegen. Zweitens ist die Lage der Anschlußklemmen wichtig, durch die der Laststrom eingespeist wird bzw. abfließt und der Basisstrom eingespeist bzw abgenommen wird. Im Ausführungsbeispiel ist die Klemme 1 am linken Ende der Leitung 12 angeordnet. Der hier eingespeiste Laststrom fließt durch die parallel geschalteten Halbleiterkörper von T1 und von dort über Bonddrähte in die Emitterleitung 9. Der Emitterstrom fließt als Strom $I_1$ nach rechts, verzweigt sich dort und fließt einerseits als Laststrom $I_L$ durch die Anschlußklemme 3 und andererseits als Diodenstrom zur Anschlußklemme 2. Die eingezeichneten Stromläufe stimmen mit dem anhand von Figur 1 beschriebenen Betriebszustand überein.

Der Transistor T1 wird durch Einspeisen von Basisstrom in die Anschlußklemme 4 leitend gesteuert. Der Basisstrom fließt über die Basis-Emitterstrecke der Transistoren T1 in die Emitterleitung 9 und über die Leitung 10 zurück zur Steuerstromquelle, wie durch die Pfeile gezeigt ist. Bei einem schnellen Anstieg des Laststroms, der zwischen den Klemmen 1 und 3 fließt, wird in diesem Bereich der Steuerkreisleitung eine Gegenspannung zur Steuerkreisspannung induziert, die den Basisstrom schwächt und das Einschalten des Transistors verlangsamt. Damit wird sowohl die an der Diode D2 anliegende Überspannung als auch der Rückstrom durch D2 herabgesetzt.

Entsprechendes gilt für den Fall, wenn der Transistor T2 mit der Diode D1 zusammenwirkt. Dies ist dann der Fall, wenn der Laststrom $I_L$ in der umgekehrten Richtung wie in Figur 1 dargestellt die Last L durchfließt. Hierzu wird der Transistor T2 leitend gesteuert. Beim Abschalten von T2 fließt dann entsprechend ein Freilaufstrom durch die Diode D1. Wird dann T2 wieder eingeschaltet, kommt es an D1 ebenfalls zu einer Überspannung und zu einem hohen Rückstrom. Das schnelle Einschalten von T2 wird durch das Auftreten einer Gegenspannung in der Basisstrom-Rückleitung 16 verhindert. Dies wird hier durch die Lage der Klemmen 2 und 17 sichergestellt.

Neben der Lage der Anschlußklemmen 11, 17 spielt auch die Lage der Anschlußklemmen 4 und 5 eine Rolle, da die Gegenkopplung auch zwischen den Basisstrom-Leitungen 8, 14 und den Leitungen 7, 12 wirkt.

Um eine wirksame Gegenkopplung sicherzustellen, ist die Lage der Laststromanschlüsse 1, 2 und die Lage der Dioden D1 und D2 derart gewählt, daß die Strombahn für den Strom des einen Transistors zusammen mit der Strombahn des Diodenstroms $I_R$ durch die dem anderen Transistor zugeordnete Diode möglichst nur in einer Richtung verläuft. Im Ausführungsbeispiel nach Figur 3 wird dies dadurch erreicht, daß die Klemme 1 am linken Ende der Anordnung und die Klemme 2 am rechten Ende der Anordnung angebracht ist. Die im dargestellten Fall auf der rechten Seite der jeweiligen Kollektorleitung 12, 7 angeordneten Halbleiterkörper von D1 und D2 können in diesem Fall auch auf der linken Seite oder zwischen den Transistor-Halbleiterkörpern angeordnet sein.

Das Ausführungsbeispiel nach Figur 4 unterscheidet sich von dem nach Figur 3 hauptsächlich dadurch, daß die Kollektorleitungen 7 und 12 bezogen auf ihre Längsachse räumlich nicht hintereinander, sondern nebeneinander und einander parallel liegen. Im übrigen sind gleiche oder funktionsgleiche Teile mit gleichen Bezugszeichen wie in Figur 3 versehen. Die Anschlußklemme 3 für den Kollektoranschluß von T2 und den Emitteranschluß von T1 liegt hier auf der rechten Seite der Emitterleitung 9. Die Anschlußklemme 11 für den Basisstrom-Rückleiter 10 liegt an seinem linken freien Ende. Hierdurch fließen Laststrom und Basisstrom einander entgegen, wodurch das langsame Einschalten von T1 gewährleistet ist. Die Diode D1 ist anodenseitig über Bonddrähte mit der Kollektor-Leiterbahn 12 von T2 verbunden. Der Transistorstrom von T1 nimmt seinen Weg entsprechend den ausgezogenen Pfeilen zur Anschlußklemme 3. Hier verzweigt er sich in den Laststrom $I_L$ und den Diodenstrom (gestrichelt gezeichnet) $I_R$. Dieser fließt zur Anschlußklemme 2 ab. Die Stromrichtung des Laststromes ist im wesentlichen von links nach rechts gerichtet. Dies wird in erster Linie durch die Lage von D2 am rechten Ende der Kollektorleitung 12 erreicht. Würde man sie am linken Ende von 12 anordnen, so würde ein Stromfluß auch von rechts nach links auftreten, das elektromagnetische Feld kompensierte sich und die Gegenkopplung würde geschwächt. Die Klemme 4 liegt am rechten Ende der Leitung 8.

Entsprechendes gilt für das Zusammenarbeiten von T2 mit der Diode D1, dessen Layout dem von T2 in FIG 3 entspricht. Hier wird eine einheitliche Stromrichtung dadurch erreicht, daß D1 am linken Ende der Kollektorleitung 7 angeordnet und durch Bonddrähte mit dem gegenüberliegenden linken Ende der Kollektorleitung 12 verbunden ist. Entsprechend sitzt die Klemme 1 am linken Ende von 7 und die Klemme 2 am rechten Ende der Emitterleitung 15. Die Klemme 5 liegt am rechten Ende der Leitung 14.

In Figur 3 und 4 sind die Basisstrom-Rückleiter auf dem Substrat aufgebrachte Leiterbahnen. Normalerweise ist dadurch keine ausreichende Gegenkopplung zu erzielen. Eine bessere Gegenkopplung wird erreicht, wenn die Basisstrom-Rückleitung 10, 16 oberhalb der Emitterleitungen 9, 15 angeordnet sind. Der Rückleiter kann, wie in Figur 5 dargestellt, beispielsweise ein ausgestanzter Blechstreifen sein, dessen eines Ende mit der Emitterleitung 9 oder dem Anschlußkontakt 3 verlötet ist. Eine entsprechende Anordnung kann für den Transistor T2 vorgesehen sein. Auch diese Rückleiter laufen der Emitterleitung parallel. Da hierdurch eine bessere Gegenkopplung als bei auf dem Substrat liegenden Rückleitungen erreicht wird, spielt hier die Lage der Klemmen 4, 5 auf den Leitungen 8, 14 praktisch keine Rolle mehr.

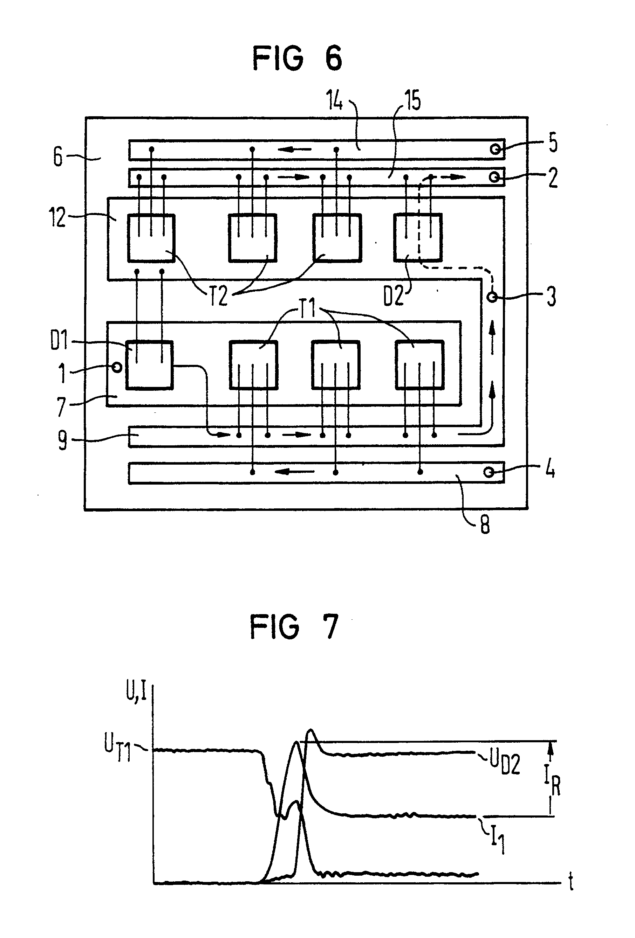

Figur 6 zeigt ein Ausführungsbeispiel, bei dem die Gegenspannung in der Basisstromleitung selbst induziert wird. Basisstromleitungen 8, 14 und die Emitterleitungen 9, 15 liegen hier jeweils auf der Außenseite der beiden einander parallel und gegenüberliegenden Kollektorleitungen 7 bzw. 12. Die Anordnung der Dioden D1 und D2 und die Lage der Anschlußkontakte 2, 3 und 4 ist hier wieder so gewählt, daß der Strompfad aus dem Transistorstrom des geöffneten Transistors (ausgezogener Pfeil) zusammen mit dem Strompfad des Diodenstroms (gestrichelter Pfeil) im wesentlichen in einer Richtung verläuft. Bei leitendem Transistor T2 wird dies dadurch erreicht, daß der Halbleiterkörper der Diode D1 benachbart der Klemme 1 liegt und anodenseitig über Bonddrähte mit der Kollektorleitung 12 verbunden ist.

Aus dem Diagramm nach Figur 7 geht hervor, daß mit der angegebenen Gegenkopplung sowohl der Strom $I_1$ durch den Transistor T1 und damit auch der Rückstrom $I_R$ durch D2 als auch die an D2 auftretende Überspannung gegenüber einem Halbleiterbauelement ohne Gegenkopplung stark herabgesetzt wird. Dies wird durch ein langsameres Schalten des Transistors erreicht. Dies drückt sich im Diagramm durch einen tendenziell langsameren Abfall der Transistorspannung $U_{T1}$ aus. Ein entsprechendes Verhalten zeigt der Transistor T2 im Zusammenspiel mit D1.

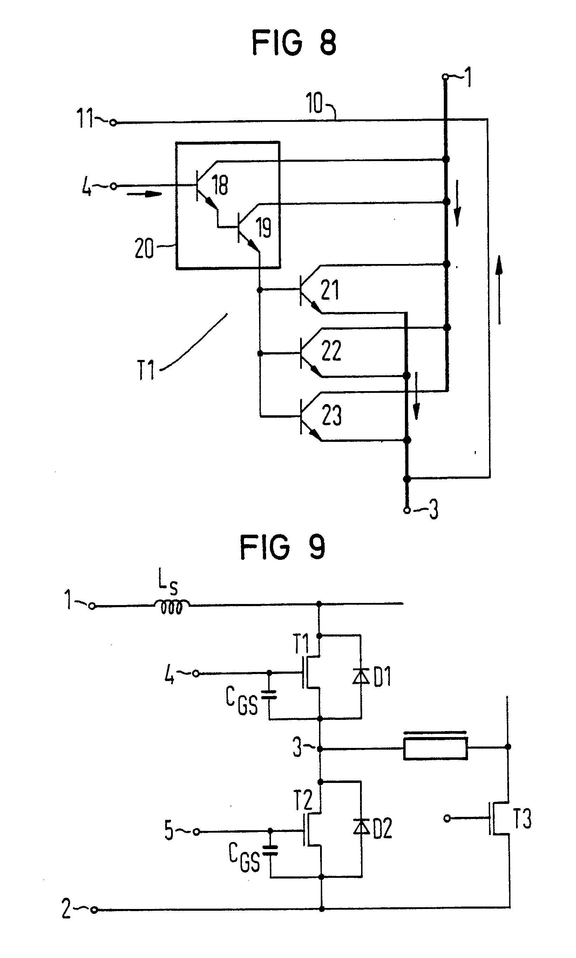

In den Ausführungsbeispielen sind die Transistoren durch jeweils drei, einander parallel geschaltete Halbleiterkörper gebildet. Ein anderer Aufbau ist möglich. So ist in Figur 8 ein Transistorschalter dargestellt, der eine aus zwei Bipolartransistoren 18, 19 gebildete Darlingtonstufe 20 enthält. Der Emitterstrom der Darlingtonstufe wird dann drei parallel geschalteten Bipolartransistoren 21, 22 und 23 zugeführt. Im übrigen sind gleiche oder funktionsgleiche Teile wie in den anderen Figuren mit gleichen Bezugszeichen versehen. Der Laststrom ist hier durch zwei abwärts gerichtete ausgezogene Pfeile und der Basis-Rückstrom durch einen aufwärts gerichteten ausgezogenen Pfeil dargestellt.

Anstelle der Bipolartransistoren für die Transistorschalter können auch Leistungs-MOSFET eingesetzt werden. Dies ist in Figur 9 gezeigt. Die Diode D1 ist hier dem MOSFET T1, bezogen auf die Stromflußrichtung durch T1, antiparallel geschaltet, wobei ihre Anode mit dem Sourceanschluß von T1 und ihre Kathode mit dem Drainanschluß verbunden ist. Die Diode D2 ist dem Leistungs-MOSFET T2, bezogen auf die Stromflußrichtung durch T2, antiparallel geschaltet. Ihre Anode ist mit dessen Sourceanschluß und ihre Kathode mit dessen Drainanschluß verbunden. Die Gatezuleitungen von T1 und T2 liegen an den Klemmen 4 bzw. 5. Entsprechend werden in den Ausführungsbeispielen nach den Figuren 3, 4 und 6 anstelle der bipolaren Halbleiterkörper MOSFET-Halbleiterkörper eingesetzt. Die Basisstromleitung wird zur Gatestromzuleitung, die Basisstrom-Rückleitung zur Gatestrom-Rückleitung, die Emitterleitung zur Sourceleitung und die Kollektorleitung zur Drainleitung. Die Gegenkopplung kann hier analog zu Figur 3 und 4 zwischen einer Gatestrom-Rückleitung und der Sourceleitung oder zwischen der Gatestrom-Leitung und der Sourceleitung wirken (Figur 6). Zweckmäßigerweise wird analog zu den Ausführungsbeispielen in Figur 3 und 4 die Gatestrom-Rückleitung wie in Figur 5 oberhalb der Sourceleitung angeordnet.

Als Halbleiterschalter können anstelle der Bipolartransistoren oder der MOSFET z. B. auch GTO-Thyristoren verwendet werden.

**Patentansprüche**

1. Halbleiterbauelement mit zwei in Reihe geschalteten Halbleiterschaltern, denen jeweils eine Freilaufdiode (D1, D2) antiparallel geschaltet ist, mit einer ersten Anschlußklemme (3) zwischen den beiden Halbleiterschaltern und mit zwei Anschlußklemmen (1, 2) zur Zuführung einer Zwischenkreisspannung, **dadurch gekennzeichnet,** daß jeder der Halbleiterschalter mindestens eine Laststrom-Leitung und mindestens eine Steuerstrom-Leitung aufweist, und daß mindestens eine der Steuerstrom-Leitungen und mindestens eine der Laststrom-Leitungen derart zueinander angeordnet sind, daß bei einem Stromanstieg in der Laststrom-Leitung in der Steuerstrom-Leitung eine Gegenspannung induziert wird.

2. Halbleiterbauelement nach Anspruch 1, **dadurch gekennzeichnet,** daß die Laststrom-Leitung der Steuerstrom-Leitung benachbart ist und ihr mindestens teilweise parallel liegt.

3. Halbleiterbauelement nach Anspruch 1 oder 2, **dadurch gekennzeichnet,** daß jeder Halbleiterschalter mindestens einen Bipolartransistor (T1, T2) enthält, daß für jeden Schalter eine auf einem Substrat (6) angeordnete Basisstrom-Leitung (8, 14), eine Emitterleitung (9, 15) und eine Kollektorleitung (7, 12) vorgesehen ist, daß die Basisstrom-Leitung entweder der Emitterleitung oder der Kollektorleitung benachbart liegt und daß die Lage der Anschlußklemme (4, 5) für die Basisstrom-Leitung (8, 14), die Lage der Kollektor-Anschlußklemme (1, 3) und die Lage der Emitter-Anschlußklemme (3, 2) derart festgelegt ist, daß der Stromfluß in den beiden genannten benachbarten Leitungen einander entgegengesetzt ist.

4. Halbleiterbauelement nach Anspruch 1 oder 2, **dadurch gekennzeichnet,** daß jeder Halbleiterschalter mindestens einen Bipolartransistor (T1, T2) enthält, daß für jeden Schalter eine auf einem Substrat (6) angeordnete Basisstrom-Leitung (8, 14) eine Emitterleitung (9, 15) und eine Kollektorleitung (7, 12) vorgesehen ist, daß für jeden Schalter eine Basisstrom-Rückleitung (10, 16) vorgesehen ist, die mit der Emitterleitung (9, 15) verbunden ist, daß die Basistrom-Rückleitung (10, 16) der Emitterleitung benachbart und mindestens teilweise parallel zu dieser angeordnet ist und daß die Lage der Anschlußklemme (11, 17) an der Basisstrom-Rückleitung, die Lage der Emitter-Anschlußklemme (2, 3) und die Lage der Verbindung zwischen Emitterleitung und Basisstrom-Rückleitung derart festgelegt ist, daß beim Einschalten der Stromfluß in diesen Leitern einander entgegengesetzt ist.

5. Halbleiterbauelement nach Anspruch 4, **dadurch gekennzeichnet,** daß die Basisstrom-Rückleitung (10, 16) im Abstand vom Substrat (6) oberhalb der Emitterleitung (9, 15) angeordnet ist.

6. Halbleiterbauelement nach Anspruch 4, **dadurch gekennzeichnet,** daß die Basisstrom-Rückleitung (10, 16) als auf dem Substrat (6) liegende Basisleiterbahn ausgebildet und neben der Emitterleitung (9, 15) angeordnet ist.

7. Halbleiterbaulement nach einem der Ansprüche 1 bis 6, **dadurch gekennzeichnet,** daß die Halbleiterkörper der Bipolartransistoren kollektorseitig und die Halbleiterkörper der Freilaufdioden (D1, D2) kathodenseitig auf den Kollektorleitungen (7, 12) sitzen und daß die Halbleiterkörper der Freilaufdioden jeweils an einer festgelegten Stelle der Kollektorleitung sitzt derart, daß der Laststrompfad durch den Transistor des einen Schalters zusammen mit dem Rückstrompfad durch die zum anderen Schalter gehörenden Freilaufdiode im wesentlichen in eine Richtung fließt.

8. Halbleiterbauelement nach einem der Ansprüche 1 bis 7, **dadurch gekennzeichnet,** daß der Halbleiterschalter jeweils aus mehreren parallel geschalteten Transistoren besteht.

9. Halbleiterbauelement nach Anspruch 8, **dadurch gekennzeichnet,** daß den Transistoren eine Darlington-Transistorstufe (20) vorgeschaltet ist.

10. Halbleiterbauelement nach Anspruch 1 oder 2, **dadurch gekennzeichnet,** daß jeder Halbleiterschalter mindestens einen Leistungs-MOSFET (T1, T2) enthält, daß für jeden Schalter eine auf einem Substrat angeordnete Gatestrom-Leitung und eine Sourceleitung vorgesehen ist, daß die Gatestrom-Leitung der Sourceleitung benachbart liegt und daß die Lage der Anschlußklemmen für diese Leitungen derart festgelegt ist, daß der beim Einschalten fließenden Stromfluß in diesen Leitungen einander entgegengesetzt ist.

11. Halbleiterbauelement nach Anspruch 1 oder 2, **dadurch gekennzeichnet,**

daß jeder Halbleiterschalter mindestens einen Leistungs-MOSFET (T1, T2) enthält, daß für jeden Schalter eine auf einem Substrat angeordnete Gatestrom-Leitung und eine Sourceleitung vorgesehen ist, daß für jeden Schalter eine Gatestrom-Rückleitung vorgesehen ist, der mit der Sourceleitung verbunden ist, daß die Gatestrom-Rückleitung und die Sourceleitung benachbart und mindestens teilweise parallel zu dieser angeordnet ist, daß die Lage der Anschlußklemmen an der Gatestrom-Rückleitung und an der Sourceleitung und die Lage der Verbindung zwischen Gatestrom-Rückleitung und Sourceleitung derart festgelegt ist, daß beim Einschalten der Stromfluß in diesen Leitungen einander entgegengesetzt ist.

## Claims

1. Semiconductor component having two semiconductor switches connected in series, to which in each case one freewheeling diode (D1, D2) is connected in antiparallel, having a first connecting terminal (3) between the two semiconductor switches and having two connecting terminals (1, 2), for supplying an intermediate circuit voltage, characterised in that each of the semiconductor switches has at least one load current line and at least one control current line, and in that at least one of the control current lines and at least one of the load current lines are arranged with respect to each other such that, in the case of an increase in current in the load current line, an opposing voltage is induced in the control current line.

2. Semiconductor component according to Claim 1, characterised in that the load current line is adjacent to the control current line and is at least partially parallel thereto.

3. Semiconductor component according to Claim 1 or 2, characterised in that each semiconductor switch contains at least one bipolar transistor (T1, T2), in that a base current line (8, 14) arranged on a substrate (8), an emitter line (9, 15) and a collector line (7, 12) are provided for each switch, in that the base current line is adjacent to either the emitter line or the collector line, and in that the position of the connecting terminal (4, 5) for the base current line (8, 14), the position of the collector connecting terminal (1, 3) and the position of the emitter connecting terminal (3, 2) are determined such that the current flow in the two stated adjacent lines is in opposite directions.

4. Semiconductor component according to Claim 1 or 2, characterised in that each semiconductor switch contains at least one bipolar transistor (T1, T2), in that a base current line (8, 14), arranged on a substrate (6), an emitter line (9, 15) and a collector line (7, 12) are provided for each switch, in that a base current return line (10, 16) which is connected to the emitter line (9, 15) is provided for each switch, in that the base current return line (10, 16) is arranged adjacent to the emitter line and at least partially parallel thereto, and in that the position of the connecting terminal (11, 17) on the base current return line, the position of the emitter connecting terminal (2, 3) and the position of the connection between the emitter line and the base current return line are determined such that, on switching on, the current flow in these lines is in opposite directions.

5. Semiconductor component according to Claim 4, characterised in that the base current return line (10, 16) is arranged at a distance from the substrate (6) above the emitter line (9, 15).

6. Semiconductor component according to Claim 4, characterised in that the base current return line (10, 16) is configured at a base conductor path located on the substrate (6) and is arranged adjacent to the emitter line (9, 15).

7. Semiconductor component according to one of Claims 1 to 6, characterised in that the semiconductor bodies of the bipolar transistors are positioned on the collector side and the semiconductor bodies of the freewheeling diodes (D1, D2) are positioned on the cathode side, on the collector lines (7, 12), and in that the semiconductor bodies of the freewheeling diodes are in each case positioned at a specific point on the collector line, such that the load current path through the transistor of one switch flows essentially in the same direction as the return current path through the freewheeling diode belonging to the other switch.

8. Semiconductor component according to one of Claims 1 to 7, characterised in that in that the semiconductor switch in each case consists of a plurality of parallel-connected transistors.

9. Semiconductor component according to Claim 8, characterised in that a Darlington transistor stage (20) is connected in front of the transistors.

10. Semiconductor component according to Claim 1 or 2, characterised in that each semiconductor switch contains at least one power MOSFET (T1, T2), in that a gate current line, arranged on a substrate, and a source line are provided for each switch, in that the gate current line is adjacent to the source line and in that the position of the connecting terminals for these lines is specified such that the current flow flowing in these lines, on switching on, is in opposite directions.

11. Semiconductor component according to Claim 1 or 2, characterised in that each semiconductor switch contains at least one power MOSFET (T1, T2), in that a gate current line, arranged on a substrate, and a source line are provided for each switch, in that a gate current return line is provided for each switch which is connected to the source line, in that the gate current return line is adjacent to the source line and is arranged at least partially parallel thereto, in that the position of the connecting terminals on the gate current return line and on the source line and the position of the connection between the gate current return line and the source line are specified such that, on switching on, the current flow in these lines is in opposite directions.

## Revendications

1. Composant à semiconducteurs comportant deux interrupteurs à semiconducteurs branchés en série, auxquels sont raccordées, selon un montage antiparallèle, des diodes à effet unidirectionnel respectives (D1,D2), et une première borne de raccordement (3) disposée entre les deux interrupteurs à semiconducteurs, et deux bornes de raccordement (1,2) pour l'amenée d'une tension de circuit intermédiaire, caractérisé par le fait que chacun des interrupteurs à semiconducteurs possède au moins un conducteur véhiculant un courant de charge et au moins un conducteur véhiculant un courant de commande, et qu'au moins l'un des conducteurs véhiculant un courant de commande et au moins l'un des conducteurs véhiculant un courant de charge sont disposés l'un par rapport à l'autre de manière que, dans le cas d'un accroissement du courant dans le conducteur véhiculant le courant de charge, une tension antagoniste est induite dans le conducteur véhiculant le courant de commande.

2. Composant à semiconducteurs suivant la revendication 1, caractérisé par le fait que le conducteur véhiculant le courant de charge est disposé au voisinage du conducteur véhiculant le courant de commande et est au moins en partie parallèle à ce conducteur.

3. Composant à semiconducteurs suivant la revendication 1 ou 2, caractérisé par le fait que chaque interrupteur à semiconducteurs contient au moins un transistor bipolaire (T1,T2), que pour chaque interrupteur, il est prévu un conducteur (8,14) véhiculant le courant de base et disposé sur un substrat (6), le conducteur d'émetteur (9,15) et un conducteur de collecteur (7,12), que le conducteur véhiculant le courant de base est situé au voisinage du conducteur d'émetteur ou du conducteur de collecteur, et que la position de la borne de raccordement (4,5) pour le conducteur (8,14) véhiculant le courant de base, la position de la borne (1,3) de raccordement du collecteur et la position de la borne (3,2) de raccordement de l'émetteur sont fixées de telle sorte que les flux de courant dans lesdits deux conducteurs voisins sont réciproquement opposés.

4. Composant à semiconducteurs suivant la revendication 1 ou 2, caractérisé par le fait que chaque interrupteur à semiconducteurs contient au moins un transistor bipolaire (T1,T2), que pour chaque interrupteur, il est prévu un conducteur (8,14) véhiculant le courant de base et disposé sur un substrat (6), un conducteur d'émetteur (9,15) et un conducteur de collecteur (7,12), que pour chaque interrupteur, il est prévu un conducteur (10,16) de retour du courant de base, qui est raccordé au conducteur d'émetteur (9,15), que le conducteur (10,16) de retour du courant de base est disposé au voisinage du conducteur d'émetteur et est au moins en partie parallèle à ce conducteur, et que la position de la borne de raccordement (11,17) sur le conducteur de retour du courant de base, la position de la borne (2,3) de raccordement d'émetteur et la position de la liaison entre le conducteur d'émetteur et le conducteur de retour du courant de base sont fixées de telle sorte que, lors de la mise à l'état conducteur, les flux de courant dans ces conducteurs sont réciproquement opposés.

5. Composant à semiconducteurs suivant la revendication 4, caractérisé par le fait que le conducteur (10,16) de retour du courant de base est situé à distance du substrat (6) au-dessus du conducteur d'émetteur (9,15).

6. Composant à semiconducteurs suivant la revendication 4, caractérisé par le fait que le conducteur (10,16) de retour du courant de base est réalisé sous la forme d'une voie conductrice de base située sur le substrat (6) et est disposée à côté du conducteur d'émetteur (9,15).

7. Composant à semiconducteurs suivant l'une des revendications 1 à 6, caractérisé par le fait que les corps semiconducteurs des transistors bipolaires côté collecteur et les corps semiconducteurs des diodes à effet unidirectionnel (D1,D2) sur le côté cathode sont disposés sur les conducteurs de collecteur (7,12) et que les corps semiconducteurs à effet unidirectionnel sont disposés respectivement en un emplacement fixé du conducteur de collecteur de sorte que la voie du courant de charge passant par le transistor du premier interrupteur ainsi que la voie de retour de courant passant par la diode à effet unidirectionnel associée à l'autre interrupteur s'étendent sensiblement dans une direction.

8. Composant à semiconducteurs suivant l'une des revendications 1 à 7, caractérisé par le fait que l'interrupteur à semiconducteurs est constitué respectivement par plusieurs transistors branchés en parallèle.

9. Composant à semiconducteurs suivant la revendication 8, caractérisé par le fait qu'en amont des transistors est branché un étage à transistors à montage Darlington (20).

10. Composant à semiconducteurs suivant la revendication 1 ou 2, caractérisé par le fait que chaque interrupteur à semiconducteurs contient au moins un transistor MOSFET de puissance (T1,T2), que pour chaque interrupteur, il est prévu un conducteur véhiculant le courant de grille, disposé sur un substrat, et un conducteur de source, que le conducteur véhiculant le courant de grille est disposé au voisinage du conducteur de source et que la position des bornes de raccordement pour ces conducteurs est fixée de telle sorte que les flux de courant, qui circulent lors de la mise à l'état conducteur, dans ces conducteurs sont réciproquement opposés.

11. Composant à semiconducteurs suivant la revendication 1 ou 2, caractérisé par le fait que chaque interrupteur à semiconducteurs contient au moins un transistor MOSFET de puissance (T1,T2), que, pour chaque interrupteur, il est prévu un conducteur véhiculant le courant de grille, disposé sur un substrat, et un conducteur de source, que, pour chaque interrupteur, il est prévu un conducteur de retour du courant de grille, qui est raccordé au conducteur de source, que le conducteur de retour du courant de grille est disposé au voisinage du conducteur de source et est disposé au moins en partie parallèlement à ce conducteur, que la position des bornes de raccordement au conducteur de retour du courant de grille et au conducteur de source et la position de la liaison entre le conducteur de retour du courant de grille et le conducteur de source sont fixées de manière que, lors de la mise à l'état conducteur, les flux de courant dans ces conducteurs sont réciproquement opposés.

# FIG 1

# FIG 2

# FIG 3

# FIG 4

# FIG 5

# FIG 6

# FIG 7

## FIG 8

## FIG 9